# FASCICULE DE BREVET EUROPEEN

(11) **EP 3 508 916 B1**
(45) Date de publication et mention de la délivrance du brevet: **02.03.2022**
(21) Numéro de dépôt: 18150436.6
(22) Date de dépôt: 05.01.2018
(51) Int. Cl.: G03F 7/00, C25D 1/00

(54) **METHODE DE FABRICATION D'UN MICROMOULE MULTI-NIVEAUX POUR ELECTROFORMAGE**
HERSTELLUNGSMETHODE EINER MEHRSTUFIGEN MIKROFORM FÜR DIE GALVANOFORMUNG
METHOD FOR MANUFACTURING A MULTI-LEVEL ELECTROFORMING MICROMOULD

(43) Date de publication de la demande: 10.07.2019
(73) Titulaire: Mimotec S.A., 1950 Sion (CH)
(72) Inventeur: LORENZ, Hubert, 1965 Savièse (CH); GENOLET, Grégoire, 1926 Fully (CH)
(74) Mandataire: Wenger, Joel-Théophile

(56) Documents cités:
- EP-A1- 2 053 146
- EP-A1- 2 157 476
- EP-A2- 0 483 484
- CH-A2- 701 266

## Description

La présente demande concerne le domaine de la fabrication de microstructures par électroformage en particulier des microstructures à plusieurs niveaux.

### Arrière-plan technique

Le procédé de fabrication de microcomposants par irradiation d'une couche photosensible aux rayons ultraviolets suivie d'une étape d'électroformage est connu et est décrit dans le brevet européen No : EP0851295B1.

Ce procédé est dérivé de la technique LIGA (Lithographie Galvanoformung Abformung) et consiste à :
- déposer sur un substrat une couche de 1 à 1000 µm d'une résine photosensible liquide appelée ci-après : photorésist,
- effectuer à travers un masque une irradiation au moyen d'un synchrotron ou par une exposition de rayons ultraviolets,
- développer, c'est-à-dire éliminer par des moyens chimiques les portions de photorésist non polymérisées et créer de ce fait une cavité en photorésist.
- électroformer un métal dans cette cavité afin d'obtenir le composant micromécanique.

L'avantage de cette technique est de réaliser des composants d'une très grande précision en X et Y et avec une épaisseur allant jusqu'à plusieurs millimètres. Il est également possible d'appliquer le procédé en plusieurs étapes pour obtenir un composant en plusieurs niveaux, chaque niveau étant construit sur le précédent.

Ce procédé est décrit plus avant dans la demande européenne No : EP1225477A1 et détaille le processus itératif des opérations de masquage, d'irradiation et de dissolution de la partie non irradiée.

Lorsque l'on souhaite obtenir des composants à plusieurs niveaux, l'homme du métier est confronté à des problèmes d'uniformité lors de l'électrodéposition qui peuvent prendre la forme de champignonnage ou de microcavités, par exemple. Ces problèmes limitent la réalisation de telles pièces. Ces problèmes sont inhérents à la croissance galvanique et sont causés en partie par la localisation de la couche conductrice nécessaire au dépôt galvanique, en particulier sur les flancs verticaux de la structure en photorésist.

Afin de contourner ces obstacles, les différentes solutions s'attachent à empêcher le dépôt de la couche de matériau conducteur (de l'or ou du cuivre en général) sur les flancs verticaux de la structure en photorésist, afin que le métal électroformé ne se dépose sélectivement que sur les surfaces horizontales du photorésist.

Une première solution consiste à déposer l'or par une évaporation directionnelle parallèle aux flancs verticaux du photorésist afin que l'or ne se dépose pas sur ces flancs. On constate que l'obtention d'un faisceau parfaitement parallèle aux flancs verticaux est très difficile et que néanmoins une quantité d'or se fixe sur ces flancs de manière totale ou partielle.

Selon une autre solution connue, on applique un masque dont les ouvertures sont ajustées aux surfaces horizontales des reliefs, pour que l'or ne se dépose que sur ces parties horizontales (technique dite du « shadow mask »). Pour être efficace, l'ouverture doit être très légèrement inférieure à la surface horizontale afin d'empêcher toute diffusion parasite qui viendrait déposer des particules d'or sur les flancs verticaux. Cette technique nécessite un alignement parfait entre la pièce et le masque ce qui peut se révéler très difficile sur des pièces de taille moyenne ainsi que sur des substrats de grande taille. Cette technique ne permet pas d'isoler totalement toutes les géométries. Toutes les structures de masquage doivent en effet être reliées au cadre du masque et génèrent des masquages parasites.

Selon une troisième solution connue, on utilise un bain électrolytique comprenant des agents nivelants. Ces agents ont pour fonction de ralentir le dépôt de métal en certains endroits afin d'en homogénéiser l'épaisseur et sont donc uniquement adaptés pour limiter le champignonnage. Leur efficacité est extrêmement dépendante de la forme de la cavité et des paramètres d électroformage.

Une quatrième solution consiste à structurer l or évaporé supplémentaire à l aide de la technique du « spray coating » et d une attaque chimique de la couche conductrice non protégée. La couche conductrice évaporée sur l ensemble du premier niveau photostructuré reçoit dans un premier temps une couche sprayée fine de photorésist. Une étape de photolithographie supplémentaire est nécessaire afin que subsiste une couche de masquage uniquement sur le dessus de la couche photostructurée. Ce masquage des faces horizontales permet d attaquer chimiquement les couches conductrices déposées sur les flancs verticaux non-protégés. La technique de dépose de photorésist par spray coating ne permet pas d obtenir des couches fines et uniformes, en particulier sur des topographies importantes avec des angles droits. Des effets de bord prononcés empêchent un dépôt uniforme. De plus, cette méthode nécessite l utilisation d une étape photolithographique complète supplémentaire avec l utilisation d un photomasque dont l alignement est très critique.

Le document EP 2 053 146 divulgue un micromoule à deux niveaux (1002; cf. fig. 25(h)) disposé sur un substrat (1) ayant une surface recouverte d'une couche conductrice (2) et comprenant une cavité comportant au moins deux niveaux horizontaux. Ce moule comprend une première structure (3a) et une deuxième structure (6a) en photorésist, la surface supérieure horizontale de la première structure étant recouverte d'une couche conductrice (5a). II est formé via un procédé LIGA. Ce document divulgue en outre des micromoules en photorésist à 3 ou 4 niveaux et comprenant une couche conductrice entre les niveaux (cf. figures 26 et 27).

Le document EP 2 157 476 décrit un procédé de fabrication de pièces métalliques multi-niveaux par la technique LIGA. Une fois la structure en photoresist développée, une couche de métallisation est appliquée selon une technique non décrite, cette couche état disposée sur les surfaces horizontales du moule en photoresist.

### Description sommaire de I invention

Ces différentes techniques ne permettent que partiellement et difficilement d'obtenir des résultats satisfaisants. Le but de la présente invention est de proposer une méthode de fabrication de micromoules autorisant un dépôt par électroformage homogène sur plusieurs niveaux.

Ce but est atteint par une méthode de fabrication de micromoules pour électroformage d'une pièce ayant au moins deux niveaux selon la revendication 1.

Cette invention permet la réalisation de micromoules à plusieurs niveaux desquels résultent la fabrication de composants électroformés tels que des roues dentées, des ancres, des roues d'ancres, des sautoirs ou tout autre composants micromécaniques.

### Description sommaire des figures

L'invention sera mieux comprise grâce à la description qui va suivre et qui se réfère aux dessins annexés donnés à titre d'exemple nullement limitatif, à savoir:

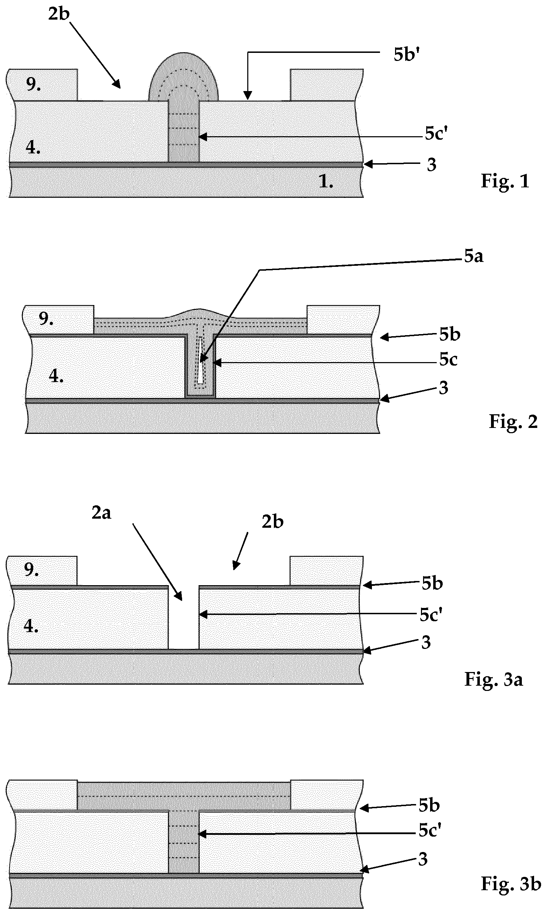

- la figure 1 illustre le problème de champignonnage sur un micromoule à deux niveaux où la couche conductrice n'est présente que sur le substrat.
- la figure 2 illustre le phénomène du champignonnage et les microcavités d'une structure à deux niveaux où la couche conductrice a été déposée uniformément sur le premier niveau de résine.
- la figure 3a illustre un micromoule à deux niveaux où la couche conductrice n'est présente que sur les surfaces supérieures de la première couche structurée de résine et est absente des flancs verticaux de la première couche structurée de résine.
- la figure 3b illustre le résultat obtenu après un électroformage.

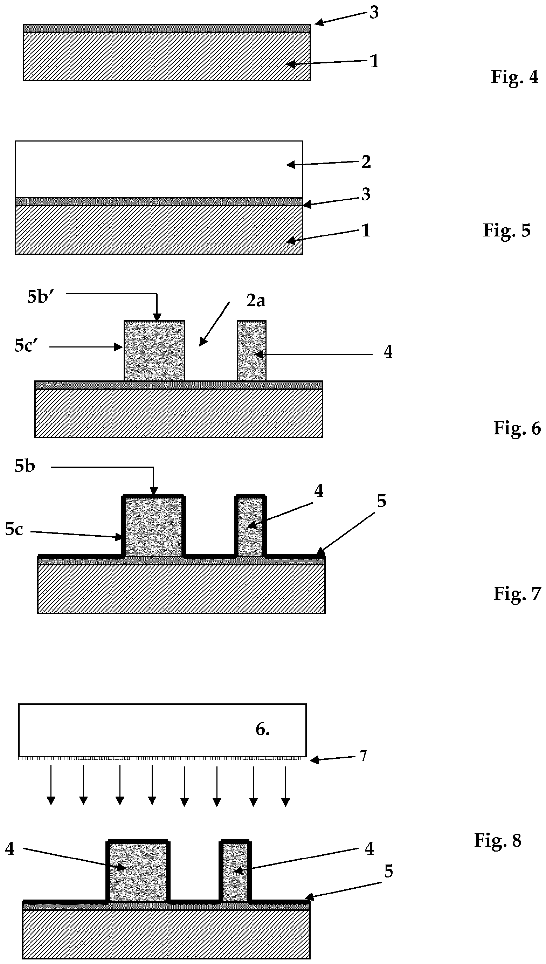

- les figures 4 à 11 illustrent les étapes du procédé selon l'invention.

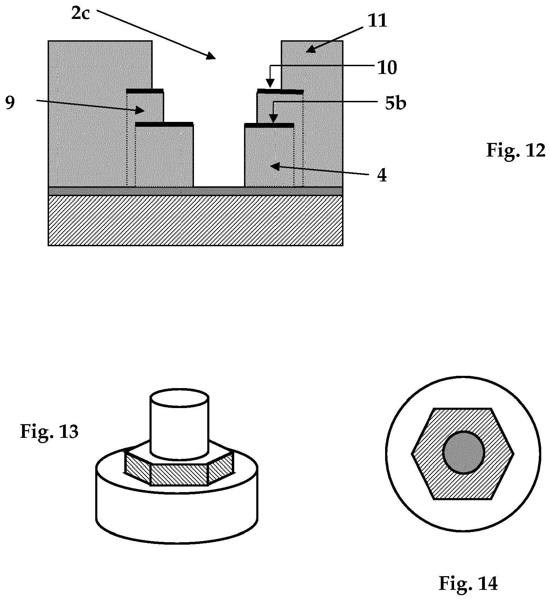

- la figure 12 illustre un exemple de micromoule à trois niveaux.
- la figure 13 illustre la vue en perspective de la pièce issue du micromoule de la figure 12.
- la figure 14 est une vue de dessus de la pièce de la figure 13.

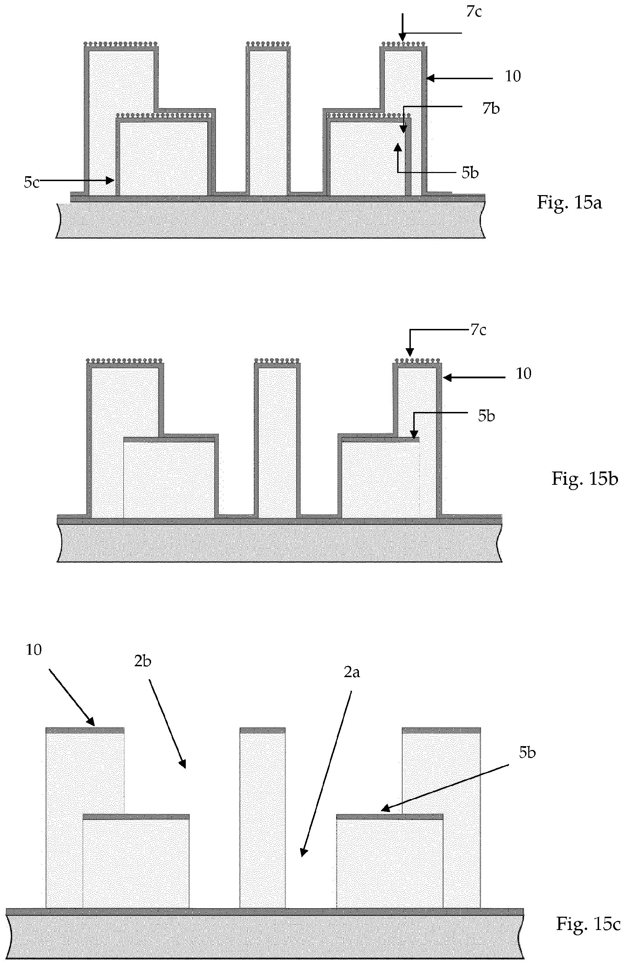

- la figure 15a illustre une étape de réalisation d'un micromoule à plusieurs niveaux.
- la figure 15b illustre une variante d'une étape de réalisation d'un micromoule à plusieurs niveaux.
- la figure 15c illustre un état intermédiaire de la fabrication d'un micromoule à trois niveaux. A cette étape les dorages sélectifs pour la cavité à trois étages sont finis.

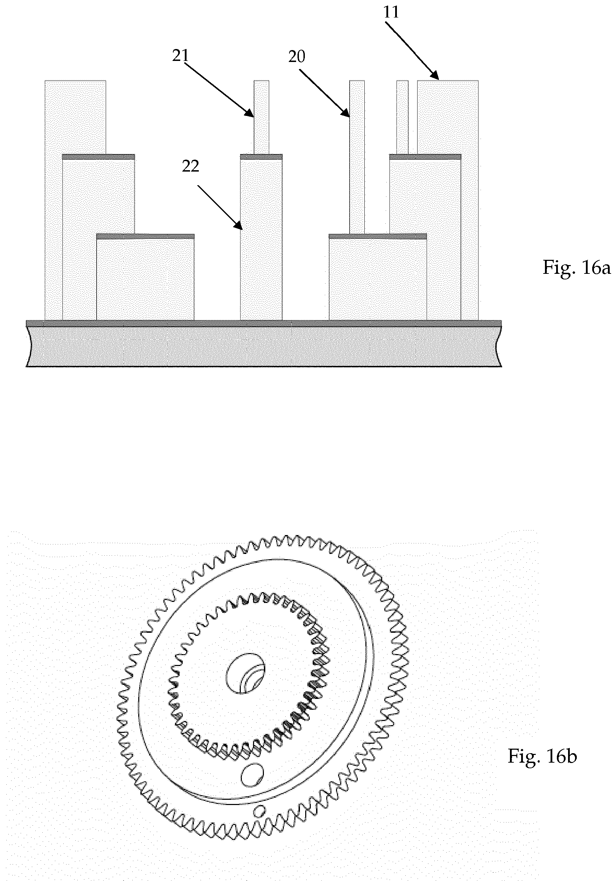

- la figure 16a illustre un exemple de micromoule à trois niveaux obtenu selon la méthode de l'invention, la couche conductrice ne recouvrant que les surfaces supérieures des première et deuxième couches structurées de résine.
- la figure 16b illustre une vue en perspective de la pièce issue du micromoule de la figure 16a.

### Description détaillée de l'invention

La particularité de l'invention est l'application d'une couche dite monocouche organique auto-assemblée de très faible épaisseur qui est déposée de façon sélective sur les surfaces horizontales supérieures du photorésist recouverte de la couche conductrice en utilisant un procédé d'impression similaire à la tampographie.

Cette couche de protection, de la famille des alkanéthiolates par exemple, est transférée de façon sélective sur les surfaces horizontales du photorésist au moyen d'un tampon. Le document intitulé « Non-Photolithographic Methods for Fabrication of Elastomeric Stamps for Use in Microcontact Printing », de Younan Xia, Joe Tien, Dong Qin, and George M. Whitesides, Department of Chemistry, Harvard University, Cambridge, Massachusetts 02138 décrit des méthodes de fabrication de tampons et de dépôt d'une monocouche. Un autre document des mêmes auteurs intitulé : « Microcontact Printing of SAMs » décrit des méthodes d'impression de monocouches structurées sur des surfaces métalliques en utilisant des tampons enduits d'un alkanéthiolate.

Cette monocouche va protéger la couche d'or sur laquelle elle est déposée lors de l'enlèvement par voie chimique des couches d'or non protégées déposées sur les flancs verticaux. Une partie de la deuxième couche d'or déposée sur le substrat sera également dissoute mais la première couche conductrice est suffisamment épaisse pour assurer la conduction lors de l'étape d'électroformage.

Une fois cette opération réalisée, il n'y a plus de contact électrique entre la couche conductrice sur le substrat et les surfaces horizontales des reliefs de la première couche polymérisée également recouvertes d'une couche conductrice. Le phénomène de champignonnage disparaît complètement puisque la couche métallique, lors de l'électroformage, va d'abord croître sur le substrat seulement jusqu'à ce que le niveau du relief soit atteint. À cette étape de la fabrication, la couche d'or déposée sur le relief de la première couche polymérisée sera électriquement connectée au substrat, permettant une croissance d'une manière homogène sur toute la surface recouverte d'or du relief exposée au bain galvanique.

Cette technique autorise la fabrication de micromoules pour électroformage composées de plusieurs couches polymérisées et superposées sur lesquelles une couche conductrice d'or est sélectivement présente.

Le micromoule final se compose donc de plusieurs reliefs s'étendant verticalement par rapport au substrat et dont les surfaces parallèles au substrat sont recouvertes d'une fine couche conductrice. Lors de l'électroformage, chaque fois que la couche électroformée atteint la hauteur d'un de ces reliefs, la couche est électriquement reliée au substrat et la croissance métallique se fait sur toute cette surface du relief.

### Description détaillée de la problématique liée au dorage sélectif à l'aide des figures

Selon la figure 1, le substrat 1 est généralement une plaque-support de verre, de métal ou de silicium sur laquelle est déposée une couche conductrice 3 réalisée par une évaporation de chrome et d'or, par exemple. Sur cette couche conductrice est déposée une couche de résine photosensible liquide et de type négatif appelée ci-après « photorésist » sensible aux rayons ultraviolets UV, typiquement de la famille du SU-8 de MicroChem Corporation.

Selon le procédé bien connu sous l'appellation LIGA, ce photorésist est sélectivement polymérisé grâce à un masque dans les régions 4, les parties non polymérisées étant éliminées par dissolution dans un solvant et créent des ouvertures 2a (voir figure 3a) dans ce premier niveau de photorésist.

Lors de la phase d'électroformage, la couche conductrice 3 au fond des ouvertures 2a permet un dépôt métallique sur ce support et lorsque le niveau défini par la couche polymérisée 4 est atteint, le dépôt continue selon une forme de champignon tel qu'illustré sur la figure 1. Si l'on souhaite remplir complètement de métal la cavité 2b, il faudra une grande quantité de métal et la formation d'un très gros "champignon" de métal avant d'arriver au résultat souhaité.

Pour éviter ce problème de champignonnage il faut métalliser la surface supérieure de la couche photostructurée 4 avant la formation de la couche photostructurée 9. Lors de cette étape les flancs verticaux 5c' de la cavité 2a sont également totalement ou partiellement recouverts de métal (5c) et rendus conducteurs. Dans ce cas et comme illustré à la figure 2, des microcavités 5a se forment dans les cavités ayant un rapport hauteur sur largeur élevé (>1). Ce phénomène provient de la croissance métallique latérale sur les flancs verticaux 5c du micromoule en photorésist, et de la vitesse de croissance inhomogène en certains endroits due au phénomène d'effet de pointe. La couche conductrice 5c présente sur les flancs verticaux 5c' est responsable des microcavités 5a dans le micromoule. La présence d'une couche conductrice 5b horizontale sur la surface horizontale du moule 5b' permet une croissance verticale sur la surface du deuxième niveau plus homogène de la couche métallique que sur l'exemple de la figure 1.

La figure 3b illustre l'objet à atteindre par la méthode de fabrication de l'invention pour la réalisation d'une pièce homogène et sans microcavité. Ce but consiste à avoir des surfaces conductrices 3 et 5b uniquement sur les couches horizontales alors que les flancs verticaux 5c' sont exempts de surfaces conductrices.

Si ce but semble logique et simple dans son énoncé, la réalisation pose des problèmes délicats et les différentes solutions exposées ci-dessus ont bien montré la difficulté de développer des procédés performants et industriellement viables.

### Description de la méthode selon l'invention à l'aide des figures

Les figures 4 à 12 indiquent la méthode de l'invention étape par étape. La figure 4 montre la plaque de base 1, sur laquelle est déposée une couche électriquement conductrice 3, réalisée par une évaporation d'or par exemple. Sur cette couche conductrice est déposée une couche de photorésist 2 (voir figure 5) sensible aux rayons ultraviolets. Cet ensemble est chauffé à une température environ de 95°C et durant un temps qui dépend de l'épaisseur et de la viscosité du photorésist utilisé.

Cette couche est ensuite irradiée selon une technique de photolithographie par une source à ultraviolets à travers une plaque en verre sur laquelle a été structuré un motif en chrome ou en or. Cette plaque avec sa découpe de chrome ou d'or est appelée un photomasque.

La lumière arrivant parfaitement perpendiculairement sur la plaque, seules les portions de photorésist non protégées par le motif en chrome seront irradiées.

Le développement consiste à éliminer le photorésist de type SU-8 non polymérisé et permet d'obtenir en relief dans le photorésist illuminé les motifs présents sur le photomasque.

On obtient ainsi la structure de la figure 6 avec les régions polymérisées 4, comportant des flancs verticaux 5c' et des surfaces horizontales 5b', qui ont une épaisseur égale à la couche de photorésist 2 déposée initialement et dont les dimensions latérales sont définies par le photomasque.

Cette étape permet de définir des ouvertures ou cavités 2a dans la première couche de photorésist 2.

L'étape suivante représentée à la figure 7 est le dépôt d'une couche d'or 5. Même si ce dépôt est le plus directionnel possible, du métal (5b,5c) va se déposer aussi bien sur les surfaces verticales 5c' qu'horizontales 5b' du photorésist. Ce dépôt s'effectue d'une manière conventionnelle par évaporation sous vide par exemple.

L'étape suivante illustrée à la figure 8 est l'étape spécifique à l'invention présentée. Une monocouche organique de protection 7 (de la famille des alkanéthiolates, par exemple) est appliquée sur un élément de transfert représenté sous forme d'une plaque de transfert 6. Lors de l'application de cette plaque 6 sur les reliefs 4, cette couche 7 de très faible épaisseur, typiquement de 1 à 5 nanomètres, va être transférée sur les surfaces d'or en contact.

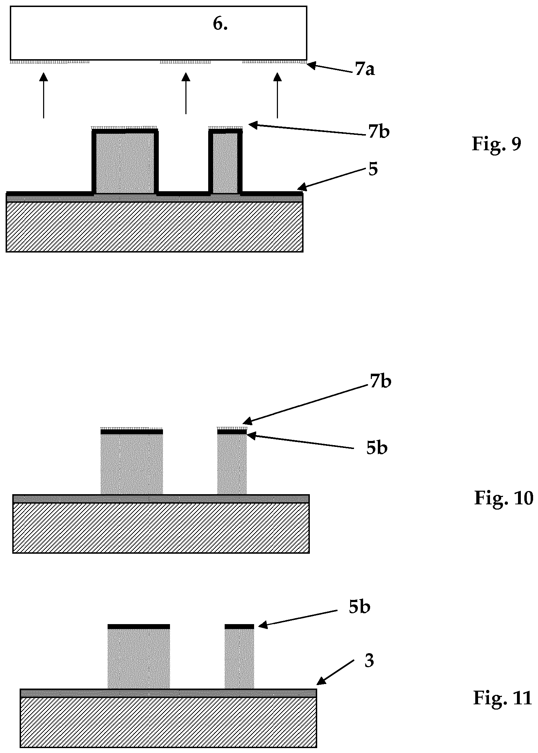

Le résultat est visible à la figure 9 où seule la partie de la couche organique 7 qui a été en contact avec la couche conductrice d'or est transférée. Cette méthode permet d'appliquer la couche de protection 7b uniquement sur l'or se trouvant sur les surfaces horizontales supérieures du photorésist. La couche de protection 7a qui n'a pas été en contact avec les surfaces horizontales supérieures du photorésist reste sur la plaque de transfert 6.

Cette couche fait office de photorésist pour masquer la couche d'or 5b comme illustré à la figure 10. En effet, une fois la monocouche organique déposée sur les surfaces horizontales des reliefs, ces surfaces sont protégées lors de l'opération d'élimination de la couche d'or via une attaque chimique humide conventionnelle.

Une fois l'or sélectivement enlevé, la monocouche organique 7b est également éliminée tel qu'illustré à la figure 11.

Pour terminer le micromoule et définir la forme et les dimensions latérales du deuxième niveau, on dépose une couche finale de photorésist déposée sur l'ensemble de la figure 11 pour délimiter la pièce horizontalement. Cette couche est ensuite irradiée au travers d'un masque approprié et la partie non polymérisée est éliminée de manière conventionnelle. On obtient ainsi un micromoule avec une cavité à deux niveaux horizontaux 2a et 2b comme illustré à la figure 3a. Le photorésist photostructuré du deuxième niveau 9 peut recouvrir une partie des reliefs 4 pour créer une limite au deuxième niveau ou peut ne reposer que sur le substrat créant une cavité entre ces deux couches polymérisées.

Le micromoule illustré par la figure 3a est disposé sur un substrat 1 ou plaque-support ayant une surface recouverte d'une couche conductrice 3 et comprend une cavité comportant au moins deux niveaux horizontaux. La cavité comprend un fond conducteur constitué par la couche conductrice 3 sur la surface du substrat 1 et un premier niveau en photorésist 4 d'une première épaisseur prédéfinie déposé sur le substrat 1. Le premier niveau comporte une première ouverture 2a ayant un premier contour photostructuré et des flancs verticaux reliant le premier contour à la couche conductrice 3 du substrat 1 au fond de la cavité. La cavité comprend un deuxième niveau en photorésist 9, déposé sur le premier niveau 4, ayant une deuxième épaisseur prédéfinie. Le deuxième niveau comporte une deuxième ouverture 2b en aplomb de la première ouverture, la deuxième ouverture ayant un deuxième contour photostructuré englobant le premier contour et des flancs verticaux reliant le deuxième contour à une surface supérieure du premier niveau. Selon une variante du micromoule, les flancs verticaux de la deuxième ouverture peuvent relier le contour de cette ouverture à la surface supérieure du premier niveau et/ou le fond de la cavité. Le micromoule est caractérisé en ce que la surface supérieure horizontale du premier niveau de photorésist 4 de la cavité 2a est entièrement recouverte d'une couche conductrice 5b. Cette couche conductrice 5b s'étend non seulement sur les surfaces supérieures visibles de la cavité du micromoule mais également sous la deuxième couche de photorésist 9 du deuxième niveau.

La méthode de l'invention permet également de fabriquer en même temps une pluralité de micromoules disposés sur un substrat ayant une surface recouverte d'une couche conductrice. Les micromoules peuvent être disposés sur tout ou partie de la surface du substrat. Le substrat comprenant un ensemble de micromoules est appelé plaque support ou wafer.

Dans le cas où l'on souhaite un micromoule composé de plus de trois niveaux ou plus, tel que représenté à la figure 12, les étapes décrites ci-dessus sont à répéter.

Le micromoule illustré par la figure 12 comprend une cavité avec un troisième niveau disposé sur le deuxième niveau de la cavité du micromoule illustré par la figure 3a. Le troisième niveau comporte une troisième ouverture 2c en aplomb de la deuxième ouverture 2b. Cette troisième ouverture a un troisième contour photostructuré englobant le premier et le deuxième contour des ouvertures des premiers et deuxièmes niveaux et des flancs verticaux reliant le troisième contour à une surface supérieure du deuxième niveau. Dans cet exemple, les surfaces supérieures horizontales du premier et du deuxième niveau sont entièrement recouvertes par une couche conductrice (10 et 5b). Par analogie au micromoule à deux niveaux la couche conductrice du premier et deuxième niveau s'étend non seulement sur les surfaces supérieures visibles de la cavité du micromoule mais également sous la deuxième et troisième couche de photorésist du deuxième et du troisième niveau.

Une pluralité de micromoules comportant des cavités à trois niveaux peuvent également être disposées sur tout ou partie d'une plaque-support de la même manière que la pluralité de micromoules avec une cavité à deux niveaux.

### Fabrication d'une base pour la réalisation d'un micromoule à 3 niveaux, première variante

Dans cette première variante de fabrication d'un micromoule à plus que deux niveaux la couche d'or 5 sur la couche polymérisée 4 n'est pas éliminée de même que la monocouche organique 7b de protection. Sur le micromoule représenté à la figure 9, on applique une nouvelle couche dite deuxième couche de photorésist qui est irradiée au travers d'un masque correspondant au contour de cette couche.

Une fois l'exposition exécutée, on élimine la partie non polymérisée de la deuxième couche et l'étape d'application de la couche conductrice 10 peut intervenir sur les parties restantes du photorésist du deuxième niveau 9.

Une fois la couche conductrice 10 déposée, on applique la plaque de transfert pour le dépôt de la monocouche organique 7c sur les surfaces horizontales des reliefs 9. Le tout est alors prêt pour l'opération d'élimination de la couche d'or sur les flancs verticaux, des reliefs 4 et des reliefs 9. Les surfaces horizontales desdits reliefs étant protégées par la monocouche organique.

La figure 15a illustre cet ensemble dans lequel la couche 4 est partiellement recouverte par les nouveaux reliefs 9 créés lors de la deuxième étape de photostructuration. Une couche conductrice 10 est déposée sur les surfaces horizontales et les flancs verticaux par évaporation sous vide d'or. La couche 5b du premier niveau est toujours protégée par la monocouche organique 7b à ce stade.

L'étape suivante consiste à attaquer chimiquement les couches d'or non protégées et à enlever la monocouche organique de protection. On obtient le micromoule illustré à la figure 15c.

### Fabrication d'une base pour la réalisation d'un micromoule à 3 niveaux, deuxième variante

Dans une deuxième variante de réalisation d'un micromoule à plus que 2 niveaux, la couche d'or sur les flancs verticaux des reliefs 4 est éliminée pour l'obtention du résultat illustré à la figure 10 et la monocouche organique 7b est ensuite enlevée comme illustré à la figure 11.

Sur le micromoule représenté à la figure 11, on applique une nouvelle couche dite deuxième couche de photorésist qui est irradiée au travers d'un deuxième photomasque correspondant au contour de cette couche.

Une fois l'exposition exécutée, on élimine la partie non polymérisée de la deuxième couche et l'étape d'application de la couche conductrice 10 puis de la couche mono-organique 7c sur cette dernière peut intervenir (figure 15b).

Ces flancs n'auront qu'une couche d'or résultant d'une opération d'évaporation d'or avec comme conséquence que le processus d'élimination sélective de l'or sur les flancs verticaux des deuxièmes reliefs 9 sera de plus brève durée. La figure 15b illustre cette variante d'exécution avant l'application de la couche de terminaison et avant l'attaque chimique des couches d'or.

Après attaque chimique de l'or et enlèvement de la monocouche organique on obtient le micromoule illustré à la figure 15c.

### Etapes finales pour la réalisation d'un micromoule à trois niveaux

Sur la base réalisée par la première ou la deuxième version décrite ci-dessus, on applique une troisième couche de photorésist dont l'épaisseur par rapport au substrat est supérieure aux deux couches précédentes. Cette couche est illuminée aux UV, puis développée pour définir le troisième niveau du micromoule.

La figure 16a montre un exemple de micromoule à trois niveaux réalisé selon la première ou la deuxième variante décrite ci-dessus. La couche conductrice recouvre entièrement les surfaces supérieures horizontales du premier et du deuxième niveau. De plus, les flancs verticaux de la troisième ouverture relient non seulement le contour de l'ouverture à la surface supérieure du deuxième niveau mais aussi la surface du premier niveau et le fond conducteur de la cavité. Par exemple, les flancs verticaux de la partie 20 du micromoule relient le contour de l'ouverture du troisième niveau à la surface supérieure du premier niveau. Les flancs verticaux de la partie 21 relient le même contour à la surface supérieure du deuxième niveau, tandis que les flancs verticaux de la partie 22 relient le contour de l'ouverture du deuxième niveau au fond de la cavité.

Comme dans l'exemple des figures 12 et 16a, les couches conductrices du premier et deuxième niveau s'étendent non seulement sur les surfaces supérieures visibles de la cavité du micromoule mais également sous la deuxième et troisième couche de photorésist du deuxième et du troisième niveau.

La figure 13 illustre une vue de côté de la pièce résultant de l'électroformage du micromoule de la figure 12 et nous montre que le premier relief 4 définit un cylindre, le deuxième relief 9 définit un hexagone et la couche de terminaison 11 définit un cylindre. La figure 14 illustre une vue de dessus du composant illustré à la figure 13.

Lors de la réalisation d'un micromoule les couches de photorésist sont en général aplanies par usinage avant les opérations d'irradiation de manière à obtenir une épaisseur uniforme sur toute leur surface. Ces étapes d'aplanissement de chacun des niveaux sont de préférence réalisées par un procédé connu sous le nom de « fly-cutting » utilisant un outil de coupe muni d'une extrémité coupante en métal dur, céramique, carbure métallique, nitrure métallique ou en diamant. La surface des différentes couches de photorésist devient ainsi parfaitement plane et parallèle au substrat avec une précision de l'ordre de 1 à 2 microns. Le document publié en octobre 2006 et intitulé : A new UV lithography photoresist based on composite of EPON resins 165 and 154 for fabrication of high-aspect-ratio microstructures, Ren Yang Et al. Department of Mechanical Engineering, Louisiana State University, 2513B CEBA, Baton Rouge, LA 70803, United States mentionne l'utilisation du « fly-cutting » dans le domaine de l'aplanissage de couches de photorésist.

## Revendications

1. Méthode de fabrication de micromoules pour électroformage d'une pièce ayant au moins deux niveaux, cette méthode comprenant les étapes suivantes :
irradiation au travers d'un premier photomasque, d'une première couche de photorésist (2) appliquée sur un substrat (1) recouvert d'une première couche conductrice (3) et définissant le premier niveau,
polymérisation de la première couche de photorésist (2) et élimination de la couche de photorésist non polymérisée, les surfaces horizontales supérieures de ladite première couche polymérisée (4) définissant la base pour un deuxième niveau,
dépôt d'une deuxième couche conductrice (5) sur la première couche de photorésist polymérisée (4) et sur les parties de la première couche conductrice (3) non recouvertes par la première couche polymérisée (4),
application sélective à l aide d un tampon d'une couche de protection (7) sur les surfaces horizontales (5b') de la première couche polymérisée (4) recouvertes de la couche conductrice (5),
élimination de la deuxième couche conductrice (5) sur les régions non protégées par la couche de protection (7b),
élimination de la couche de protection (7b),
dépôt, irradiation au travers d'un deuxième photomasque, et développement d'une deuxième couche de photorésist (9) ayant une épaisseur, par rapport au substrat, supérieure à la première couche photostructurée (4), les surfaces horizontales supérieures de ladite couche polymérisée (9) définissant un deuxième niveau du micromoule et une base pour un éventuel troisième niveau.

2. Méthode selon la revendication 1, **caractérisée en ce que** la couche de protection est une monocouche organique de la famille des alkanéthiolates.

3. Méthode selon la revendication 2, **caractérisée en ce qu'**elle comprend de plus les étapes suivantes :
dépôt d'une troisième couche conductrice (10) sur la deuxième couche de photorésist polymérisée (9), sur la première couche polymérisée (4) ainsi que sur les parties de la première couche conductrice (3) non recouvertes par les couches de photorésist polymérisée (4, 9),
application sélective à l aide d un tampon d'une deuxième couche de protection (7c) sur les surfaces horizontales de la deuxième couche polymérisée (9) recouvertes de la couche conductrice (10),
élimination de la troisième couche conductrice (10) sur les régions non protégées par la couche de protection,
élimination de la deuxième couche de protection.
dépôt, irradiation au travers d'un troisième photomasque et développement d'une couche finale de photorésist (11) d'une épaisseur, par rapport au substrat, supérieure aux couches polymérisées (4, 9).

4. Méthode selon les revendications 1, 2 ou 3, **caractérisée en ce que** chaque couche de photorésist est aplanie avant les étapes d irradiation.

## Patentansprüche

1. Verfahren zur Herstellung von Mikroformen für die Galvanoformung eines Teils mit mindestens zwei Ebenen, wobei das Verfahren die folgenden Schritte umfasst Bestrahlung einer ersten Fotoresistschicht (2) durch eine erste Fotomaske hindurch, die auf ein mit einer ersten leitenden Schicht (3) bedecktes Substrat (1) aufgebracht ist und die erste Ebene definiert,
Polymerisation der ersten Fotoresistschicht (2) und Entfernung der unpolymerisierten Fotoresistschicht, wobei die oberen horizontalen Flächen der ersten polymerisierten Schicht (4) die Basis für eine zweite Ebene bilden,
Abscheiden einer zweiten leitenden Schicht (5) auf der gehärteten ersten Fotoresistschicht (4) und auf den Teilen der ersten leitenden Schicht (3), die nicht von der gehärteten ersten Schicht (4) bedeckt sind,
selektives Aufbringen einer Schutzschicht (7) auf die horizontalen Flächen (5b') der ersten polymerisierten Schicht (4), die von der leitenden Schicht (5) bedeckt ist, mit Hilfe eines Pads,
Entfernung der zweiten leitenden Schicht (5) in den nicht durch die Schutzschicht (7b) geschützten Bereichen,
Entfernen der Schutzschicht (7b),
Abscheidung, Bestrahlung durch eine zweite Fotomaske und Entwicklung einer zweiten Fotoresistschicht (9), deren Dicke in Bezug auf das Substrat größer ist als die der ersten Fotostrukturierten Schicht (4), wobei die oberen horizontalen Flächen der gehärteten Schicht (9) eine zweite Ebene der Mikroform und eine Basis für eine mögliche dritte Ebene definieren.

2. Verfahren nach Anspruch 1, **dadurch gekennzeichnet, dass** die Schutzschicht eine organische Monoschicht aus der Familie der Alkanethiolate ist.

3. Verfahren nach Anspruch 2, **dadurch gekennzeichnet, dass** es außerdem die folgenden Schritte umfasst:
Abscheidung einer dritten leitenden Schicht (10) auf der zweiten polymerisierten Fotoresistschicht (9), auf der ersten polymerisierten Schicht (4) und auf den Teilen der ersten leitenden Schicht (3), die nicht von den polymerisierten Fotoresistschicht en (4, 9) bedeckt sind,
selektives Aufbringen einer zweiten Schutzschicht (7c) auf die horizontalen Flächen der zweiten polymerisierten Schicht (9), die von der leitenden Schicht (10) bedeckt sind,
Entfernung der dritten leitenden Schicht (10) auf den nicht durch die Schutzschicht geschützten Bereichen,
Entfernung der zweiten Schutzschicht,
Abscheidung, Bestrahlung durch eine dritte Fotomaske und Entwicklung einer abschließenden Fotoresistschicht (11), deren Dicke in Bezug auf das Substrat größer ist als die der polymerisierten Schichten (4, 9).

4. Verfahren nach einem der Ansprüche 1, 2 oder 3, **dadurch gekennzeichnet, dass** jede Fotoresistschicht vor den Bestrahlungsschritten planarisiert wird.

## Claims

1. A method for manufacturing micro molds for electroforming a piece having at least two levels, said method comprising the following steps:
irradiation through a first photomask of a first photoresist layer (2) applied to a substrate (1) covered with a first conductive layer (3) and defining the first level,
polymerization of the first photoresist layer (2) and removal of the unpolymerized photoresist layer, the upper horizontal surfaces of said first polymerized layer (4) defining the base for a second level,
depositing a second conductive layer (5) on the cured first photoresist layer (4) and on the parts of the first conductive layer (3) not covered by the cured first layer (4),
selective application of a protective layer (7) to the horizontal surfaces (5b') of the first polymerized layer (4) covered by the conductive layer (5) by means of a stamp,
removing the second conductive layer (5) on the areas not protected by the protective layer (7b) removal of the protective layer (7b),
deposition, irradiation through a second photomask, and development of a second photoresist layer (9) having a thickness, with respect to the substrate, greater than the first photostructured layer (4), the upper horizontal surfaces of said polymerized layer (9) defining a second level of the micro mold and a base for a possible third level.

2. The method according to claim 1, **characterized in that** the protective layer is an organic monolayer of the alkanethiolate family.

3. Method according to claim 2, **characterized in that** it further comprises the following steps:
deposition of a third conductive layer (10) on the second polymerized photoresist layer (9), on the first polymerized layer (4) and on the parts of the first conductive layer (3) not covered by the polymerized photoresist layers (4, 9),
selective application of a second protective layer (7c) to the horizontal surfaces of the second polymerized layer (9) covered by the conductive layer (10),
removing the third conductive layer (10) on the areas not protected by the protective layer,
removal of the second protective layer,
deposition, irradiation through a third photomask and development of a final photoresist layer (11) with a thickness, relative to the substrate, greater than the polymerized layers (4, 9).

4. A method according to claims 1, 2 or 3, **characterized in that** each photoresist layer is planarized before the irradiation steps.
